# DEMANDE DE BREVET EUROPEEN

(11) **EP 1 780 662 A1**
(43) Date de publication de la demande: **02.05.2007**
(21) Numéro de dépôt: 05292277.0
(22) Date de dépôt: 27.10.2005
(51) Int. Cl.: G06K 19/077, H05K 3/28

(54) **Module renforcé pour carte à puce et procédé de fabrication dudit module**

(71) Demandeur: Axalto SA, 92120 Montrouge (FR)
(72) Inventeur: Reignoux, Yves, 92120 Montrouge (FR)
(74) Mandataire: Cour, Pierre

(57) **Abrégé**

Un module renforcé est réalisé par moulage. Ce module combine la rigidité d'une pastille de renfort 5 avec la précision de dimension obtenue par moulage. Le module est réalisé par moulage d'un matériau d'enrobage 8 sur un ensemble grille 2-puce 1 à l'aide d'un moule dans lequel une pastille de renfort 5 a été placée préalablement à l'étape de moulage.

## Description

L'invention se rapporte à un module électronique renforcé pour carte à puce ainsi qu'à son procédé de fabrication. L'invention se rapporte également à une carte à puce incluant ledit module.

Les cartes à puce sont des cartes, généralement en plastique, disposant d'au moins un circuit intégré destiné à interagir avec un lecteur de carte. Le circuit intégré peut être un circuit électronique complexe comprenant par exemple un microprocesseur, de la mémoire et au moins une interface de communication. Le circuit intégré est placé à l'intérieur d'un module avant d'être placé dans la carte. Le module a notamment pour but de protéger le circuit intégré, également appelé « puce », vis à vis de contraintes physiques appliquées à la carte tel que, par exemple, des contraintes en flexion et/ou en écrasement.

Actuellement, il est connu d'avoir des modules destinés à une interface de communication par contact et des modules destinés à une interface de communication sans contact. Quelle que soit l'interface de communication, un module comprend généralement une grille métallique supportant le circuit intégré. La grille métallique et le circuit intégré sont éventuellement séparés par un substrat isolant. Des plots de contact du circuit intégré sont reliés électriquement à des zones de contact de la grille métallique, par exemple à l'aide de fils de liaison très fins. Le circuit intégré et les fils de liaison sont ensuite enrobés de résine pour renforcer la tenue mécanique du module.

Une première technique d'enrobage consiste à déposer une goutte de résine sur le circuit intégré et les fils de liaison, puis à déposer une pastille de renfort sur la goutte avant que celle-ci ne soit solidifiée. Une telle technique est décrite, par exemple, dans la demande de brevet EP 0 644 507. Le résultat obtenu correspond au module de la figure 1, qui est très satisfaisant en terme de rigidité et en terme simplicité de fabrication. L'inconvénient principal de cette technique réside dans la maîtrise des dimensions de l'enrobage. Il est difficile d'obtenir une précision latérale de la taille de la goutte qui soit inférieure à 300 µm. En outre, la précision en épaisseur est au mieux de l'ordre de 50 µm. La cavité de la carte devant recevoir un module réalisé selon cette technique doit avoir des dimensions présentant un jeu important autour du module. Pour une carte à interface par contact, le module est placé dans une cavité après lamination de la carte, et cela ne pose aucun problème si ce n'est d'avoir une surface de collage du module réduite. Pour une carte sans contact, la lamination se fait après avoir inséré le module dans la carte et il apparaît une déformation importante au niveau de la cavité. Cette déformation est très visible sur la carte finie et n'est pas très esthétique.

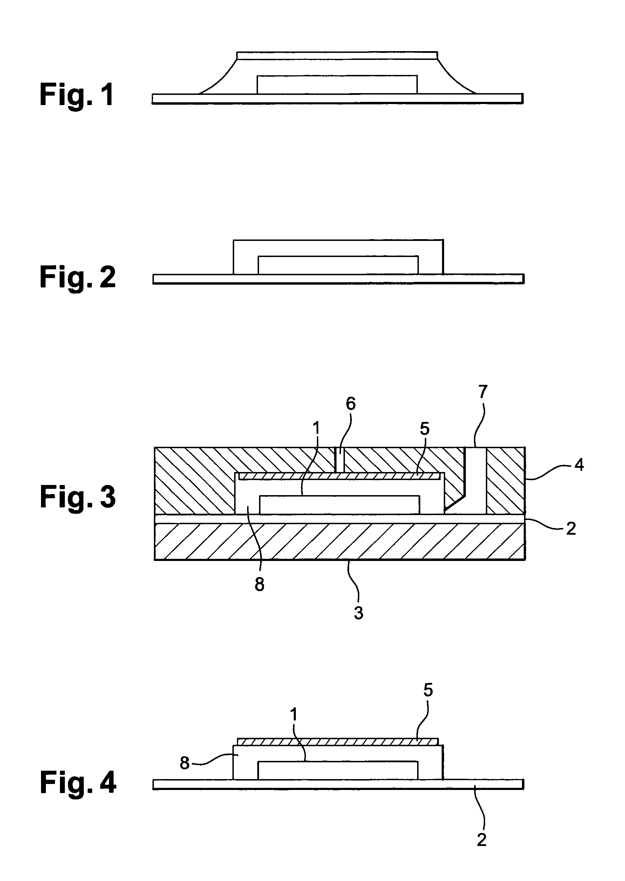

Une deuxième technique d'enrobage est dérivée des procédés d'encapsulation de circuit intégré. L'ensemble, comprenant la grille métallique, le circuit intégré et les fils de liaison, est placé dans un moule et on injecte de la résine sous pression. Le résultat obtenu correspond au module de la figure 2. La précision sur les dimensions obtenues est de l'ordre de 15 µm quelle que soit la direction. Cette technique permet de réaliser des cavités à faible jeu qui ne sont pas visibles après lamination. L'inconvénient de cette deuxième technique est que les modules ainsi réalisés sont plus fragiles qu'avec la première technique ce qui limite son utilisation à des circuits intégrés de petites dimensions ou à des applications soumises à peu de contraintes mécaniques afin de réduire l'amplitude des contraintes mécaniques exercées sur le module.

Ces deux techniques ne mettent pas en oeuvre les mêmes procédés de fabrication et sont apparemment incompatibles pour un homme du métier.

Le procédé est choisi en fonction du type de carte pour lequel le module est destiné, la deuxième technique étant principalement utilisée pour des cartes sans contact utilisant de petits circuits intégrés, tel que par exemple des cartes d'accès. Cependant, il apparaît actuellement des cartes sans contact qui demande des puces de taille importante, tel que par exemple des cartes bancaires ou des cartes d'identité. Dans le cas ces cartes, les contraintes mécaniques subies sont très importantes. Le porteur de la carte peut, par exemple, la placer dans la poche arrière de son pantalon et s'asseoir dessus ce qui engendre d'importantes contraintes de flexion et d'écrasement de la carte et donc du module. L'utilisation de modules réalisés selon la deuxième technique n'est pas la plus adaptée pour ce type d'utilisation et la marque de la cavité obtenue en utilisant des modules réalisés selon la première technique n'est pas acceptable sur ce type de produit.

L'invention propose un nouveau type de module renforcé réalisé par moulage. Ainsi, l'invention combine la rigidité d'une pastille de renfort avec la précision d'un moulage de la résine.

Selon un premier aspect, l'invention est un module électronique pour carte à puce qui comporte une grille métallique, un circuit intégré, des moyens de liaison, un matériau d'enrobage et une pastille de renfort. La grille métallique comporte au moins deux zones de contact. Le circuit intégré est placé sur une face de ladite grille métallique, ledit circuit intégré comprenant au moins deux plots de contact. Les moyens de liaison relient électriquement chaque zone de contact à un plot de contact. Le matériau d'enrobage moulé sur la face de la grille métallique qui supporte le circuit intégré et recouvrant le circuit intégré et les moyens de liaison. La pastille de renfort est placée sur le matériau d'enrobage.

Selon différents modes de réalisation, le matériau d'enrobage est choisi parmi les matériaux suivant : résine époxy, polyester, silicone ou polyuréthane. La pastille de renfort est constituée d'une couche métallique et/ou d'une couche isolante. La couche métallique est choisie parmi l'un des matériaux suivant : aluminium, cuivre, inox ou acier. La couche isolante est choisie parmi l'un des matériaux suivant : fibre de verre, verre époxy, PET, résine réticulée, film plastic, PEEK, PEI ou polyimide. La pastille de renfort a une épaisseur comprise entre 50 et 110 µm. Le module comprend en outre un substrat isolant placé sur la grille métallique.

Selon un deuxième aspect, l'invention est un procédé de fabrication d'un module pour carte à puce qui comporte les étapes de :
- placement d'un circuit intégré sur une grille métallique,
- réalisation de liaisons électriques entre le circuit intégré et la grille métallique,
- placement et maintient d'une pastille de renfort au fond d'un moule,
- placement de l'ensemble constitué de la grille métallique et du circuit intégré dans le moule, le circuit intégré étant placé entre la pastille de renfort et la grille métallique,
- injection sous pression d'un matériau d'enrobage sous forme liquide,
- durcissement du matériau d'enrobage,
- démoulage du module ainsi constitué.

Préférentiellement, le moule comporte au moins une plaque inférieure sur laquelle est posée la grille métallique, et au moins une deuxième plaque présentant une cavité. Le circuit intégré est placé sur une face de la grille opposée à la plaque inférieure et venant se placer à l'intérieure de la cavité préalablement à l'étape d'injection.

Selon un premier mode de réalisation, la cavité du moule est une cavité non-débouchante au fond de laquelle est placée la pastille de renfort préalablement au placement du circuit intégré. La pastille de renfort est maintenue au fond de la cavité par aspiration.

Selon un deuxième mode de réalisation, la cavité est une cavité débouchante. Le moule comporte une plaque supérieure venant enserrer une bande d'approvisionnement de pastilles de renfort. Ladite pastille est maintenue solidaire de ladite bande jusqu'au démoulage du module. La bande est réalisée dans le même matériau que la pastille de renfort, et dans ladite pastille est prédécoupée dans ladite bande de sorte que, lors du démoulage, la séparation du moule provoque la rupture des points d'attache reliant la pastille à la bande.

Selon un troisième aspect, l'invention est une carte à puce comportant un corps de carte muni d'une cavité dans laquelle un module tel que défini précédemment et/ou obtenu selon le procédé indiqué est placé dans ladite cavité.

L'invention sera mieux comprise, et d'autres particularités et avantages apparaîtront à la lecture de la description qui va suivre, la description faisant référence aux dessins annexés, parmi lesquels :
les figures 1 et 2 montrent des modules réalisés selon l'état de la technique,
la figure 3 illustre un premier procédé de fabrication d'un module selon l'invention,
la figure 4 montre un module conforme à l'invention, et
les figures 5 à 8 illustrent un deuxième procédé de fabrication d'un module selon l'invention.

Un premier procédé de fabrication est illustré à l'aide de la figure 3. Ce procédé de fabrication utilise un moule en deux parties. Préalablement au moulage, le circuit intégré 1 est collé sur une grille métallique 2 et des fils de liaison (non représentés pour ne pas charger inutilement le dessin) sont disposés pour effectuer la connexion électrique entre les plots de contact du circuit intégré 1 et des zones de contact de la grille métallique. A titre d'exemple, les zones de contact peuvent être au nombre de deux pour un module de carte sans contact, ou de 5 à 8 pour un module de carte conforme à la norme ISO 7816.

La grille métallique 2 est préférentiellement solidaire d'une bande de transport reliant plusieurs grilles. Cette bande de transport sert à convoyer l'ensemble dans le moule. Egalement, la grille métallique 2 pourrait être recouverte d'un substrat isolant placé entre le circuit intégré 1 et ladite grille 2. Le substrat isolant peut également se trouver du même côté que le circuit intégré mais peut présenter une découpe au niveau du circuit intégré afin de ne pas ajouter de surépaisseur. De même, les fils de liaison peuvent être remplacer par des contacts directs ou rapportés par des billes conductrices, des plots de soudure, ou tout autre moyen de contact utilisé pour le collage renversé de la puce également connue sous le nom de technique « flip-chip ».

Le moule comporte une partie inférieure 3 et une deuxième partie 4. La partie inférieure 3 est préférentiellement une partie fixe sur laquelle se déplace la bande de transport qui amène l'ensemble comprenant le circuit intégré 1 collé sur la grille métallique 2 après avoir réaliser les liaisons électriques. La deuxième partie 4 du moule comporte une cavité définissant la forme du moulage à effectuer. Le positionnement de l'ensemble se fait selon une technique connue alors que la deuxième partie 4 du moule est séparée de la partie inférieure 3.

Lorsque la deuxième partie 4 du moule est séparée de la partie inférieure 3, la deuxième partie 4 du moule est retournée afin de pouvoir y déposer par gravité une pastille de renfort 5. Un trou 6 situé au fond de la deuxième partie 4 du moule est reliée à un circuit en dépression afin de permettre le maintien de la pastille 5 par aspiration. La deuxième partie 4 du moule peut alors être positionnée par-dessus la grille métallique 2 et le circuit intégré 1. Le moule étant refermé, le circuit intégré 1 se trouve être placé entre la pastille 5 et la grille 2.

Le positionnement de la deuxième partie 4 du moule étant réalisé, celui-ci est pressé contre la partie inférieure 3 du moule. Puis, On injecte un matériau d'enrobage à l'état liquide par un trou de coulée 7. Le matériau d'enrobage est injecté sous pression. On attend un durcissement du matériau d'enrobage 8 avant d'ouvrir le moule afin d'obtenir le module renforcé tel que représenté sur la figure 4.

Le matériau d'enrobage est par exemple de la résine transfert époxy connue pour être utilisée en moulage, ou du polyester, de la silicone ou encore du polyuréthane. La résine est préchauffée pour être rendue liquide puis injectée dans le moule. Une fois dans le moule, celui-ci est chauffé pour solidifier la résine par réticulation. Le chauffage dure de quelques secondes à quelques minutes suivant la résine choisie. Lors du durcissement la pastille 5 devient solidaire de la résine et ses caractéristiques mécaniques participent à la tenue mécanique du module. Après durcissement de la résine la tolérance liée au retrait de matière est de l'ordre de 15 µm.

La pastille 5 peut être choisie parmi différents matériaux suivant les caractéristiques souhaitées. On peut choisir d'avoir recours à une pastille conductrice comportant une couche métallique afin de protéger le module contre d'éventuelles attaques de la puce par rayonnement électromagnétique.

Pour un montage de puce de type flip-chip, il est possible d'utiliser une pastille 5 métallique par exemple en cuivre, en aluminium, en inox ou autre acier. Pour un montage avec fils de liaisons, il est préféré d'avoir recours à un matériau isolant tel que par exemple de la fibre de verre, du verre époxy ou du PET. Si l'on souhaite bénéficier d'une pastille métallique tout en ayant des fils de liaison il est préféré d'avoir une pastille composite comportant une couche métallique et une couche isolante. La couche isolante ayant pour but d'éviter tout risque de contact entre les fils de liaison et la pastille. La couche isolante peut être constituée de résine réticulée déposée ou d'un film polymère, par exemple en PEEK, PEI ou polyimide, collé sur la couche métallique.

Quelle que soit la pastille 5 utilisée, il convient que celle-ci soit la plus fine possible pour éviter d'ajouter une épaisseur supplémentaire au module. En outre, la pastille 5 doit avoir une épaisseur minimale pour que les effets mécaniques de la pastille soient réels sur le module. Une épaisseur totale de la pastille comprise entre 50 et 110 µm correspond à une gamme d'épaisseurs préférée.

A titre d'exemple pour la réalisation d'un module destiné à une carte sans contact, il est possible d'utiliser une grille métallique 2 de 80 µm d'épaisseur avec une puce 1 de 70 à 120 µm. On choisit une pastille de 50 µm d'épaisseur et on utilise un moule avec une profondeur de cavité de 250 µm. Le module réalisé a une épaisseur finale d'environ 330 µm, et la distance entre la puce 1 et la pastille 5 se trouve être d'environ 130*µ*m.

La réalisation du procédé décrit précédemment est relativement complexe en terme industriel. La machine à mettre en oeuvre pour le moulage du module doit comporter un moule avec une partie pivotante reliée à un circuit de mise sous vide et à un circuit d'injection sous pression qui incorpore des moyens de chauffage. En outre, les pastilles 5 doivent être placées dans la deuxième partie 4 du moule une par une avec un dispositif de préhension relativement précis. Ce procédé n'est pas très adapté pour l'utilisation d'un moule comportant plusieurs cavités pour réaliser simultanément plusieurs modules.

Pour permettre une meilleure mise en oeuvre industrielle, il est possible de simplifier le moule en inversant la partie haute et la partie basse du moule. Toutefois, cela pose un problème pour l'approvisionnement des ensembles grille/puce. A cet effet, on propose un deuxième procédé de fabrication. Tout d'abord, pour éviter le placement de la pastille 5 à l'aide d'un outil de préhension, on propose de faire un approvisionnement en bande. Le positionnement s'effectue alors plus simplement par guidage et arrêt de la bande lorsque celle-ci est en position. En terme d'approvisionnement, les pastilles 5 et les ensembles de grille 2 et circuit intégré 1 sont fournis parallèlement de la même manière que les pastilles 5, ce qui simplifie la réalisation de la machine.

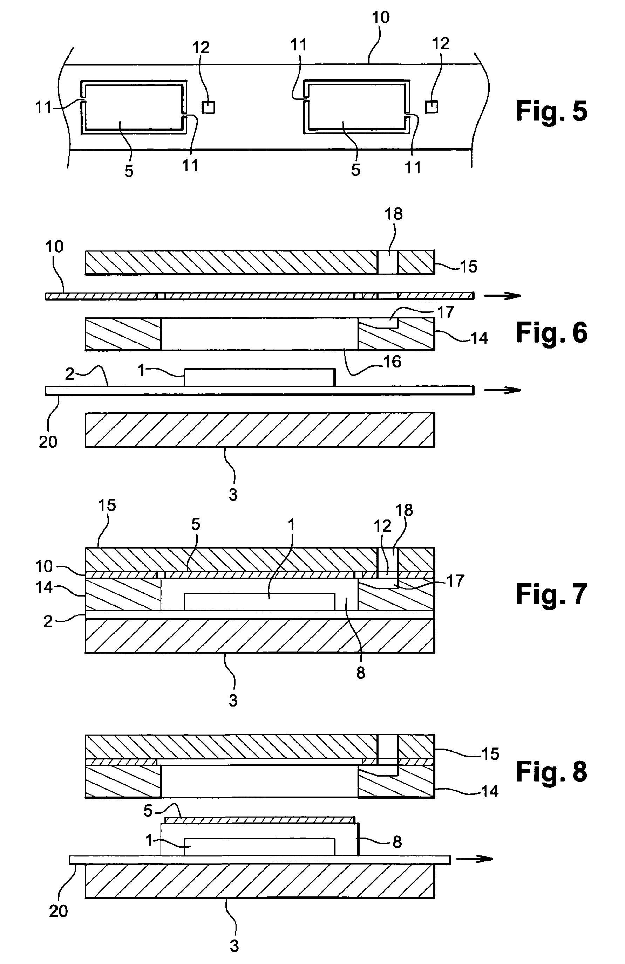

Plutôt que d'avoir recours à une bande porteuse sur laquelle est collée la pastille, il est préféré d'utiliser une bande telle que représentée sur la figure 5. La bande 10 est une bande réalisée dans le même matériau que la pastille 5. Cette bande 10 est prédécoupée pour formée les pastilles 5 qui y sont maintenues par exemple à l'aide d'au moins deux points d'attache 11. La distance entre deux pastilles correspond à la distance entre deux empreintes du moule et/ou à la distance minimale pour qu'une pastille ne soit pas endommagée lorsque la pastille voisine est dans le moule.

Dans le mode de réalisation préféré, l'approvisionnement de la résine se fait à travers la bande 10. A cet effet, un trou 12 est pratiqué à coté de chaque pastille 5 pour laisser passer la résine lors du moulage du module correspondant.

Le moule utilisé est un moule en trois parties : une partie inférieure 3, une deuxième partie 14 et une partie supérieure 15. La figure 6 représente le moule ouvert lors de son approvisionnement en pastille et en ensemble grille/puce. La partie inférieure 3 est préférentiellement une partie fixe sur laquelle se déplace la bande de transport 20 qui amène l'ensemble comprenant le circuit intégré 1 collé sur la grille métallique 2 après avoir réaliser les liaisons électriques.

La deuxième partie 14 du moule comporte une ouverture 16 qui défini le pourtour du moulage à effectuer et une zone de coulée 17. La deuxième partie 14 du moule est placé au-dessus de la partie inférieure 3 et est mobile en translation de sorte que, lorsque le moule est ouvert, la bande de transport 20 puisse se déplacer entre la partie inférieure et la deuxième partie 14.

La partie supérieure 15 du moule constitue le fond de la cavité de moulage qui sert à fermer l'ouverture 16. Cette partie supérieure 15 comporte un trou de coulée 18 venant en regard de la zone de coulée 17. La partie supérieure 15 est placée au-dessus de la deuxième partie 14 et est mobile en translation de sorte que la bande 10 puisse se déplacer entre ces deux parties lorsque le moule est ouvert.

Lorsque les bandes 10 et 20 sont correctement positionnées, le moule peut être refermé comme montré sur la figure 7. Une presse assure l'étanchéité du moule est le matériau d'enrobage 8 peut être injecté sous pression dans la cavité de moulage définie par le moule. L'effet de la presse maintient la pastille 5, solidaire de la bande 10, au fond du moule. L'injection liquide du matériau d'enrobage se fait à travers le trou de coulée 18, le trou 12 et la zone de coulée 17.

Après le durcissement du matériau d'enrobage, on peut procéder au démoulage. Préférentiellement, la deuxième partie 14 et la partie supérieure sont levée solidairement comme montré sur la figure 8. La bande 20 étant maintenue, par des moyens non représentés, contre la partie inférieure 3, ce soulèvement provoque la rupture des points d'attache 11 et de la carotte de coulée.

La deuxième partie 14 et la partie supérieure 15 peuvent ensuite être séparées l'une de l'autre pour libérer la bande 10. Il est à noter que la carotte de coulée correspondant à la zone 17 et au trou de coulée 18 peut rester solidaire de la bande 10 et permettre l'évacuation de ce déchet. Le moule étant complètement ouvert, il est alors possible de déplacer les bandes 10 et 20 simultanément pour évacuer la carotte et le module réalisé tout en préparant le moulage suivant.

Le module est ensuite découpé, par exemple par poinçonnage, de la bande de transport 20 puis placé dans une carte à puce.

## Revendications

1. Module électronique pour carte à puce qui comporte :
- une grille métallique (2) comprenant au moins deux zones de contact,
- un circuit intégré (1) placé sur une face de ladite grille métallique (2), ledit circuit intégré (1) comprenant au moins deux plots de contact,
- des moyens de liaison pour relier électriquement chaque zone de contact à un plot de contact,
- un matériau d'enrobage (8) moulé sur la face de la grille métallique (2) qui supporte le circuit intégré (1) et recouvrant le circuit intégré et les moyens de liaison,
**caractérisé en ce qu'**il comporte une pastille de renfort (5) placée sur le matériau d'enrobage.

2. Module selon la revendication 1, dans lequel le matériau d'enrobage (8) est choisi parmi les matériaux suivant : résine époxy, polyester, silicone ou polyuréthane.

3. Module selon l'une des revendications 1 ou 2, dans lequel la pastille de renfort (5) est constituée d'une couche métallique et/ou d'une couche isolante.

4. Module selon la revendication 3, dans lequel la couche métallique est choisie parmi l'un des matériaux suivant : aluminium, cuivre, inox ou acier, et dans lequel la couche isolante est choisie parmi l'un des matériaux suivant : fibre de verre, verre époxy, PET, résine réticulée, film plastic, PEEK, PEI ou polyimide.

5. Module selon l'une des revendications 1 à 4, dans lequel la pastille de renfort (5) a une épaisseur comprise entre 50 et 110 µm.

6. Module selon l'une des revendications 1 à 5, comprenant en outre un substrat isolant placé sur la grille métallique (2).

7. Procédé de fabrication d'un module pour carte à puce **caractérisé en ce qu'**il comporte les étapes de :
- placement d'un circuit intégré (1) sur une grille métallique (2),
- réalisation de liaisons électriques entre le circuit intégré (1) et la grille métallique (2),
**caractérisé en ce qu'**il comporte en outre les étapes de :
- placement et maintient d'une pastille de renfort (5) au fond d'un moule (4, 14, 15),
- placement de l'ensemble constitué de la grille métallique (2) et du circuit intégré (1) dans le moule (3, 4, 14, 15), le circuit intégré (1) étant placé entre la pastille de renfort (5) et la grille métallique (2),
- injection sous pression d'un matériau d'enrobage (8) sous forme liquide,
- durcissement du matériau d'enrobage (8),
- démoulage du module ainsi constitué.

8. Procédé selon la revendication 7, dans lequel le moule comporte au moins une plaque inférieure (3) sur laquelle est posée la grille métallique (2), et au moins une deuxième plaque (4, 14) présentant une cavité, le circuit intégré (1) étant placé sur une face de la grille (2) opposée à la plaque inférieure (3) et venant se placer à l'intérieure de la cavité préalablement à l'étape d'injection.

9. Procédé selon la revendication 8, dans lequel la cavité du moule est une cavité non-débouchante au fond de laquelle est placée la pastille de renfort (5) préalablement au placement du circuit intégré.

10. Procédé selon la revendication 9, dans lequel la pastille de renfort (5) est maintenue au fond de la cavité par aspiration.

11. Procédé selon la revendication 8, dans lequel la cavité est une cavité débouchante et dans lequel le moule comporte une plaque supérieure (15) venant enserrer une bande (10) d'approvisionnement de pastilles de renfort (5), ladite pastille (5) étant maintenue solidaire de ladite bande (10) jusqu'au démoulage du module.

12. Procédé selon la revendication 11, dans lequel la bande (10) est réalisée dans le même matériau que la pastille de renfort (5), et dans lequel ladite pastille (5) est prédécoupée dans ladite bande (10) de sorte que, lors du démoulage, la séparation du moule provoque la rupture des points d'attache (11) reliant la pastille (5) à la bande (10).

13. Procédé selon l'une des revendications 7 à 12, dans lequel le matériau d'enrobage (8) est choisi parmi les matériaux suivant : résine époxy, polyester, silicone ou polyuréthane.

14. Procédé selon l'une des revendications 7 à 13, dans lequel la pastille de renfort (5) est constituée d'une couche métallique et/ou d'une couche isolante.

15. Procédé selon la revendication 14, dans lequel la couche métallique est choisie parmi l'un des matériaux suivant : aluminium, cuivre, inox ou acier, et dans lequel la couche isolante est choisie parmi l'un des matériaux suivant : fibre de verre, verre époxy, PET, résine réticulée, film plastic, PEEK, PEI ou polyimide.

16. Carte à puce comportant un corps de carte muni d'une cavité, **caractérisé en ce qu'**un module selon l'une des revendications 1 à 6 et/ou obtenu selon le procédé de l'une des revendications 7 à 13 est placé dans ladite cavité.
